# EUROPEAN PATENT SPECIFICATION

(11) **EP 2 339 053 B1**
(45) Date of publication and mention of the grant of the patent: **06.05.2020**
(21) Application number: 10195901.3
(22) Date of filing: 20.12.2010
(51) Int. Cl.: C30B 29/36, C30B 25/10, C30B 25/12, C30B 23/06

(54) **Manufacturing apparatus and manufacturing method of silicon carbide single crystal**
Herstellungsvorrichtung und Herstellungsverfahren eines Silizium-Carbid-Einkristalls
Appareil de fabrication et procédé de fabrication de monocristal de carbure de silicium

(30) Priority: 24.12.2009 JP 2009292850
(43) Date of publication of application: 29.06.2011
(73) Proprietor: DENSO CORPORATION, Kariya-city, Aichi-pref., 448-8661 (JP)
(72) Inventor: Hara, Kazukuni, Aichi-pref., 448-8661 (JP)
(74) Representative: Winter, Brandl, Fürniss, Hübner, Röss, Kaiser, Polte - Partnerschaft mbB

(56) References cited:
- EP-A1- 1 205 584
- EP-A2- 1 464 735
- WO-A1-98/33961
- WO-A1-2004/111316
- WO-A2-2008/014434
- DE-A1- 3 230 727
- DE-A1- 19 842 109
- GB-A- 1 498 459
- JP-A- 11 278 985
- JP-A- 2003 002 795
- JP-A- 2004 311 649
- JP-A- 2006 321 681
- US-A- 6 045 613
- GEISER J ET AL: "Transient numerical study of temperature gradients during sublimation growth of SiC: Dependence on apparatus design", JOURNAL OF CRYSTAL GROWTH, ELSEVIER, AMSTERDAM, NL, vol. 297, no. 1, 15 December 2006 (2006-12-15), pages 20-32, XP025157409, ISSN: 0022-0248, DOI: 10.1016/J.JCRYSGRO.2006.08.046 [retrieved on 2006-12-15]

## Description

The present invention relates to a manufacturing apparatus and a manufacturing method of a silicon carbide single crystal.

JP-A-2002-362998 discloses a manufacturing apparatus of SiC single crystal that restricts deposition of a SiC polycrystal at an unnecessary place other than a growth surface of SiC single crystal so that growth of the SiC single crystal can be performed for a long time.

The manufacturing apparatus restricts deposition of a SiC polycrystal at an unnecessary place by introducing etching gas, which can etch the SiC polycrystal, around a pedestal on which a seed crystal is disposed.

When the etching gas is used, a necessary growing portion on a surface of the SiC single crystal may also be etched. Thus, a growth rate of the SiC single crystal may be reduced. In addition, even when the etching gas is used, a source gas in the vicinity of the pedestal may not be unsaturated and deposition of a SiC polycrystal may not be restricted sufficiently. When the etching gas includes HCl, carbon residue may be generated. When the etching gas includes hydrogen, a growth chamber made of carbon may be etched. Furthermore, when the etching gas is used, equipment for supplying the etching gas is required and a cost increases.
Document WO 2004/111316 A1 discloses a system for growing silicon carbide with substrate support means in a first end zone, silicon introducing means in a second end zone and a central zone in which carbon and silicone come substantially in contact. Input means for etching gas are arranged in the first end zone in the vicinity of the support means and of exhaust output means.
Document EP 1 464 735 A2 relates to an equipment and method for manufacturing silicon carbide single crystal. A single crystal is disposed on a crystal substrate which is disposed on a cover which is connected to a cylinder portion. The cover may be cooled by coolant gas.

WO 2008/014434 A2 relates to a crystal growth method and reactor design in which a seed holder 108 has a washer on which the seed is attached surrounded by a drool which is held by a threaded ring at a main body.

In the manufacturing method for producing silicon carbide crystal of document EP 1 205 584 A1, a cooling gas is supplied to an opposite side to a seed crystal at a pedestal so that the pedestal is cooled.

Document JP 2003-2795 A discloses a method for producing a silicon carbide single crystal in a reaction vessel on an initial surface. Document US 6045613 A describes the production of bulk single crystals of silicon carbide with low defect density. Document JP 11 278985 A describes a method for producing a single crystal with reduced defects. A bored portion is disposed in a graphite lid for locally cooling the seed crystal growth surface. The apparatus for seeding crystals of document DE 198 42 109 A1. For avoiding radial radiation of heat from the crystal it is surrounded by a heat isolating ring in the vicinity.

In view of the foregoing problems, it is an object of the present inventino to provide a manufacturing apparatus and a manufacturing method of SiC single crystal that can restrict deposition of a SiC polycrystal around a pedestal on which a seed crystal is disposed.

This object is solved by the subject matter of claims 1 and 6.

According to a first aspect of the present invention, a manufacturing apparatus for growing a SiC single crystal on a surface of a seed crystal that is made of a SiC single crystal substrate by supplying a source gas of SiC from a lower side of a vacuum chamber toward the seed crystal includes a pedestal, a rod member, and a cooling system. The pedestal is disposed in the vacuum chamber. The pedestal has a first surface on which the seed crystal is disposed and a second surface opposed to the first surface. The rod member holds the pedestal. The cooling system includes a temperature control pipe and a coolant temperature controller. The temperature control pipe is disposed on a second surface side of the pedestal. The coolant temperature controller controls a temperature of a coolant that flows to the temperature control pipe.

In the manufacturing apparatus, the temperature control pipe can cool the pedestal from the second surface side. Thus, a temperature around the pedestal can be higher than a temperature of a surface of the seed crystal disposed on the first surface of the pedestal. Therefore, the manufacturing apparatus can restrict deposition of a SiC polycrystal around the pedestal.

According to an aspect not part of the present invention, a manufacturing method of a SiC single crystal uses a manufacturing apparatus that includes a vacuum chamber, a pedestal, a rod member, and a cooling system. The pedestal is disposed in the vacuum chamber. The pedestal has a first surface on which a seed crystal made of a SiC single crystal substrate is disposed and a second surface opposed to the first surface. A source gas of SiC is supplied from a lower side of the vacuum chamber toward the seed crystal. The rod member holds the pedestal. The cooling system includes a temperature control pipe and a coolant temperature controller. The temperature control pipe is disposed on a second surface side of the pedestal. The coolant temperature controller controls a temperature of a coolant that flows to the temperature control pipe. The pedestal includes a circular plate, a housing portion, and a heat insulator. The circular plate has the first surface and the second surface. The housing portion is disposed on the second surface of the circular plate along a circumference of the circular plate. The heat insulator is disposed inside the housing portion and surrounds the rod member. The cooling system further includes an induction heating power source. The cooling system controls a heating quantity of the temperature control pipe by supplying electric power from the induction heating power source to the temperature control pipe. The cooling system controls a cooling quantity of the temperature control pipe by controlling the temperature of the coolant with the coolant temperature controller. The heat insulator divides a space in the housing portion into an inner region inside the heat insulator and an outer region outside the heat insulator. The temperature control pipe includes a first temperature control pipe and a second temperature control pipe whose temperatures are independently controllable. The first temperature control pipe is disposed in the inner region and the second temperature control pipe is disposed in the outer region. The manufacturing method not part of the present invention includes growing the SiC single crystal on the seed crystal in a state where a temperature of a peripheral portion of the circular plate is set to be higher than a temperature of a center portion of the circuit plate by supplying electric power from the induction heating power source to the second temperature control pipe while cooling the inner region with the first temperature control pipe by controlling the temperature of the coolant with the coolant temperature controller.

In the above-described manufacturing method, the temperature control pipe can heat the peripheral portion of the second surface while cooling the center portion of the second surface. Thus, a temperature difference can be provided between the center portion and the peripheral portion of the pedestal and deposition of a SiC polycrystal around the pedestal can be restricted efficiently.

According to a second aspect of the present invention, a manufacturing method of a SiC single crystal uses a manufacturing apparatus that includes a vacuum chamber, a pedestal, a rod member, and a cooling system. The pedestal is disposed in the vacuum chamber. The pedestal has a first surface on which a seed crystal made of a SiC single crystal substrate is disposed and a second surface opposed to the first surface. A source gas of SiC is supplied from a lower side of the vacuum chamber toward the seed crystal. The rod member holds the pedestal. The cooling system includes a temperature control pipe and a coolant temperature controller. The temperature control pipe is disposed on the second surface side of the pedestal. The coolant temperature controller controls temperature of coolant that flows to the temperature control pipe. The cooling system further includes a height control portion that controls a height of the temperature control pipe from the second surface of the pedestal. The manufacturing method includes growing the SiC single crystal on the seed crystal while moving the temperature control pipe closer to the second surface of the pedestal with growth of the SiC single crystal.

In the above-described method, a temperature of a growth surface of the seed crystal can be maintained at a predetermined temperature by controlling the height of the temperature control pipe. Thus, a SiC single crystal of high quality can be manufactured while restricting deposition of a SiC polycrystal around the pedestal.

Additional objects and advantages of the present invention will be more readily apparent from the following detailed description of preferred embodiments when taken together with the accompanying drawings. In the drawings:
FIG. 1 is a cross-sectional view showing a manufacturing apparatus of a SiC single crystal according to a first embodiment of the present invention,
FIG. 2 is an enlarged view of a part of the manufacturing apparatus shown in FIG. 1;
FIG. 3A and FIG. 3B are diagrams showing states of a SiC single crystal manufactured with a manufacturing apparatus according to a second embodiment of the present invention;
FIG. 4 is a cross-sectional view showing a part of a manufacturing apparatus of a SiC single crystal according to a third embodiment of the present invention;
FIG. 5 is a cross-sectional view showing a part of a manufacturing apparatus of a SiC single crystal according to a fourth embodiment of the present invention;
FIG. 6 is a cross-sectional view showing a part of a manufacturing apparatus of a SiC single crystal according to a fifth embodiment of the present invention;
FIG. 7 is a cross-sectional view showing a part of a manufacturing apparatus of a SiC single crystal according to a sixth embodiment of the present invention; and
FIG. 8 is a cross-sectional view showing a part of a manufacturing apparatus of a SiC single crystal according to a seventh embodiment of the present invention.

### (First Embodiment)

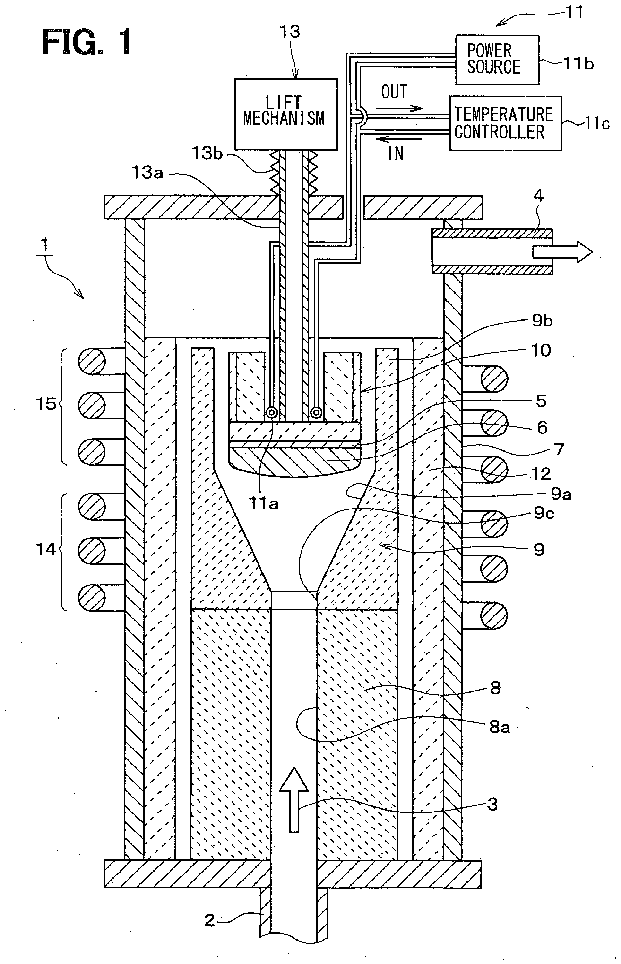

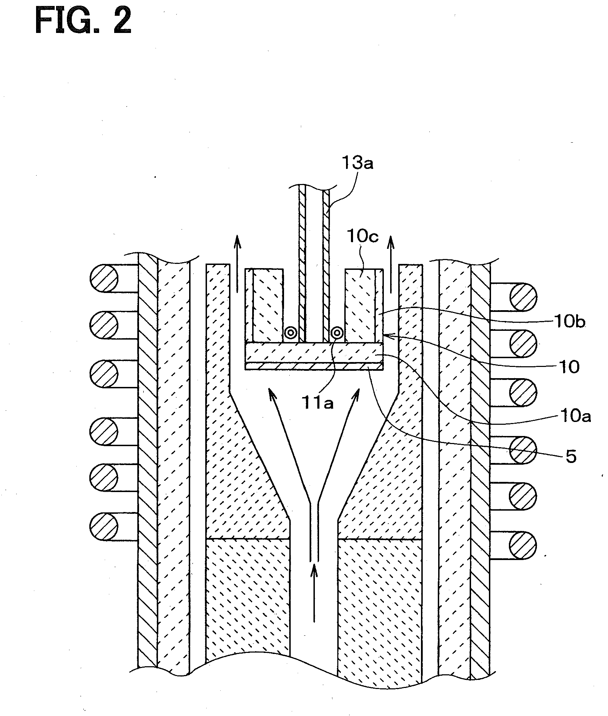

A manufacturing apparatus 1 of a SiC single crystal according to a first embodiment of the present invention will be described with reference to FIG. 1 and FIG. 2.

The manufacturing apparatus 1 supplies a source gas 3 of SiC with carrier gas through an inlet 2 provided at a bottom and discharging the carrier gas and the source gas 3 through an outlet 4, and thereby causes a crystal growth of a SiC single crystal 6 on a seed crystal 5. The source gas 3 of SiC includes Si and C. For example, the source gas 3 is mixed gas of silane-based gas including silane and hydrocarbon-based gas including propane. The seed crystal 5 is disposed in the manufacturing apparatus 1 and is made of a SiC single crystal substrate.

The manufacturing apparatus 1 includes a vacuum chamber 7, a first heat insulator 8, a reaction crucible 9, a pedestal 10, a cooling system 11, a second heat insulator 12, a rotating lift mechanism 13, a first heating device 14 and a second heating device 15.

The vacuum chamber 7 is made of, for example, silicon. The vacuum chamber 7 has a hollow cylindrical shape. The vacuum chamber 7 can introduce, for example, argon gas therein. The vacuum chamber 7 houses other components of the manufacturing apparatus 1 in an internal space thereof. A pressure in the internal space can be reduced by vacuuming. The inlet 2 of the source gas 3 is provided at the bottom portion of the vacuum chamber 7 and the outlet 4 of the source gas 3 is provided at an upper portion (specifically, an upper portion of a sidewall).

The first heat insulator 8 has a cylindrical shape. The first heat insulator 8 is coaxially-arranged with the vacuum chamber 7, and a hollow part configurates a source gas introducing pipe 8a. The first heat insulator 8 is made of, for example, graphite or graphite whose surface is coated with TaC (tantalum carbide).

The reaction crucible 9 is made of, for example, graphite or graphite whose surface is coated with TaC. The reaction crucible 9 is disposed on an upstream of a flow channel of the source gas 3 with respect to the pedestal 10. The source gas 3 supplied from the inlet 2 is decomposed in the reaction crucible 9 and is introduced to the seed crystal 5. The source gas 3 recrystallizes on a surface of the seed crystal 5, and thereby the SiC single crystal 6 grows on the surface of the seed crystal 5.

The reaction crucible 9 includes a hollow cylindrical member including a taper portion 9a, an outer peripheral portion 9b, and a gas inlet 9c. The outer peripheral portion 9b is located on a downstream side of the flow channel of the source gas 3 with respect to the taper portion 9a. The gas inlet 9c is located at an upstream end of the taper portion 9a adjacent to the first heat insulator 8. The gas inlet 9c communicates with the source gas introducing pipe 8a. The taper portion 9a has an internal diameter that gradually increases from a side adjacent to the first heat insulator 8 toward the pedestal 10. The outer peripheral portion 9b has an internal diameter that is same as the internal diameter of a downstream end of the taper portion 9a adjacent to the outer peripheral portion 9b. The outer peripheral portion surrounds the pedestal 10. The source gas 3 passing through the source gas introducing pipe 8a is introduced into the reaction crucible 9 through the gas inlet 9c.

The pedestal 10 has, for example, a cylindrical shape with a bottom and is coaxially-arranged with a center axis of the reaction crucible 9. The pedestal 10 is made of, for example, graphite or graphite whose surface is coated with TaC (tantalum carbide). As shown in FIG. 2, the pedestal 10 includes a circular plate 10a, a housing portion 10b, and a heat insulator 10c. The circular plate 10a has a first surface on which the seed crystal 5 is disposed and a second surface opposed to the first surface. The housing portion 10b is located on the downstream side of the flow channel with respect to the circular plate 10a. The housing portion 10b has a cylindrical shape that faces the outer peripheral portion 9b of the reaction crucible 9. In other words, the housing portion 10b is disposed on the second surface of the circular plate 10a along a circumference of the circular plate 10a. The heat insulator 10c is disposed inside the housing portion 10b. The circular plate 10a and the seed crystal 5 have the same dimension. The SiC single crystal 6 grows on the surface of the seed crystal 5. The rotating lift mechanism 13 includes a pipe 13a. An end of the pipe 13a is inserted into a hollow part of the housing portion 10b. The pipe 13a is in contact with the second surface of the circular plate 10a. Because the heat insulator 10c is disposed adjacent to the housing portion 10b, a temperature of a space in the housing portion 10b and a temperature around the pedestal 10 can be thermally separated.

The cooling system 11 cools the circular plate 10a of the pedestal 10 from the second surface side so as to decrease a temperature of a surface of the seed crystal 5 and a growth surface of the SiC single crystal 6 compared with a temperature around the pedestal 10. The cooling system 11 includes a temperature control pipe 11a, an induction heating power source 11b, a coolant temperature controller 11c. The temperature control pipe 11a is disposed in the housing portion 10b of the pedestal 10. The induction heating power source 11b controls a heating quantity of the temperature control pipe 11a. The coolant temperature controller 11c controls a cooling quantity of the temperature control pipe 11a. The temperature control pipe 11a includes a cooling pipe made of a RF coil. The temperature control pipe 11a can control the heating quantity in accordance with electric power supplied from the induction heating power source 11b. In addition, the temperature control pipe 11a can control the cooling quantity in accordance with a coolant temperature set by the coolant temperature controller 11c. The temperature control pipe 11a makes at least one circuit around the pipe 13a. In the temperature control pipe 11a, a coolant supplied from the coolant temperature controller 11c flows. The coolant used for cooling the surface of the seed crystal 5 and the growth surface of the SiC single crystal 6 returns to the coolant temperature controller 11c. The vacuum chamber 7 has a hole in which the temperature control pipe 11a is inserted. The hole is sealed so as to keep a vacuum state.

The second heat insulator 12 is disposed along a sidewall of the vacuum chamber 7 and has a hollow cylindrical shape. The second heat insulator 12 is made of, for example, graphite or graphite whose surface is coated with TaC. The second heat insulator 12 surrounds the reaction crucible 9 and the pedestal 10. The second heat insulator 12 introduces the source gas 3 toward the outlet 4. The remaining of the source gas 3 after supplied to the seed crystal 5 passes through a clearance between the pedestal 10 and the second heat insulator 12 and is introduced to the outlet 4.

The rotating lift mechanism 13 rotates and lifts the pipe 13a. The rotating lift mechanism 13 includes a bellows 13b and a rotating mechanism. The bellows 13b lifts the pipe 13a. The rotating mechanism includes, for example, a motor. One end of the pipe 13a is coupled with the second surface of the circular plate 10a of the pedestal 10. The other end of the pipe 13a is coupled with a body of the rotating lift mechanism 13. The vacuum chamber 7 has a hole in which the pipe 13a is inserted, and the hole is closed with the bellows 13b. Accordingly, the pipe 13a can move up and down. In addition, the pipe 13a is rotated with the rotating mechanism.

This structure makes it possible to rotate and lift the pedestal 10, the seed crystal 5 and the SiC signal crystal 6 with the pipe 13a and to control a temperature of the growth surface of the SiC single crystal to have a predetermined temperature distribution and to be a temperature appropriate to the growth accompanied with the growth of the SiC single crystal. The pipe 13a is also made of, for example, graphite or graphite whose surface is coated with TaC. Because the pipe 13a is provided for holding the pedestal 10, the pipe 13a does not need to have a pipe shape as long as the pipe 13a is a rod member that can function as a rotating shaft and a lifting shaft.

The first and second heating devices 14 and 15 include, for example, induction heating coils or heaters, and are arranged so as to surround the vacuum chamber 7. Temperatures of the first and second heating devices 14 and 15 are independently controllable. Thus, the temperature can be controlled more finely. The first heating device 14 is disposed at a position corresponding to the upstream end of the pedestal 10 and the reaction crucible 9. The second heating device 15 is disposed at a position corresponding to the reaction chamber provided by the pedestal 10. Because of this arrangement, by controlling the first and second heating devices 14 and 15, the temperature distribution of the reaction chamber can be controlled to be a temperature appropriate to the growth of the SiC single crystal 6 and the temperature of the reaction crucible 9 can be controlled to be a temperature appropriate to the removal of particles.

Next, a manufacturing method not part of the present invention of the SiC single crystal 6 with the manufacturing apparatus 1 will be described.

Firstly, the first and second heating devices 14 and 15 are controlled so that a predetermined temperature distribution is provided. In other words, the temperature is controlled so that the SiC single crystal 6 grows on the surface of the seed crystal 5 by recrystalizing the source gas 3 and a recrystalizing rate is higher than a subliming rate in the reaction crucible 9. For example, the first and second heating devices 14 and 15 are controlled so that the temperature in the reaction crucible 9 becomes 2400 °C and the temperature of the surface of the seed crystal 5 becomes 2200 °C.

In addition, as shown by arrows in FIG. 2, while keeping a pressure in the vacuum chamber 7 to a predetermined pressure, the source gas 3 is introduced through the gas introducing pipe 8a with introducing carrier gas of inert gas such as argon gas as necessary. Accordingly, the source gas 3 flows as shown by the arrows in FIG. 2 and is supplied to the seed crystal 5 so that the SiC single crystal 6 grows.

At this time, the temperature control pipe 11a is supplied with induced current from the induction heating power source 11b and is supplied with the coolant from the coolant temperature controller 11c so that the temperature of the temperature control pipe 11a becomes an appropriate temperature. The temperature control pipe 11a cools the circular plate 10a of the pedestal 10 from the second surface side.

Thus, even when the heating temperature with the second heating device 15 is increased, the temperature of the surface of the seed crystal 5 can be cooled to be a predetermined temperature. Therefore, the temperature around the pedestal 10 is kept to be, for example, about 2400 °C while keeping the temperature of the surface of the seed crystal 5, for example, about 2200 °C. In other words, by cooling the circular plate 10a of the pedestal 10 from the second surface side, the temperature around the pedestal 10 can be higher than a temperature of a center portion of the pedestal 10. Accordingly, deposition of a SiC polycrystal around the pedestal 10, on which the seed crystal 5 is disposed, can be restricted without etching gas.

Because deposition of a SiC polycrystal around the pedestal 10 can be restricted, clogging of the clearance between the pedestal 10 and the second heat insulator, that is, clogging of the flow channel of the source gas 3 can be restricted. Thus, the SiC single crystal 6 can grow successively.

As described above, the manufacturing apparatus 1 according to the present embodiment includes the temperature control pipe 11a on the second surface side of the circular plate 10a of the pedestal 10 and cools the circular plate 10a with the temperature control pipe 11a. Thus, the temperature around the pedestal 10 can be higher than the temperature of the surface of the seed crystal 5. Therefore, deposition of a SiC polycrystal around the pedestal 10 can be restricted without etching gas.

### (Second Embodiment)

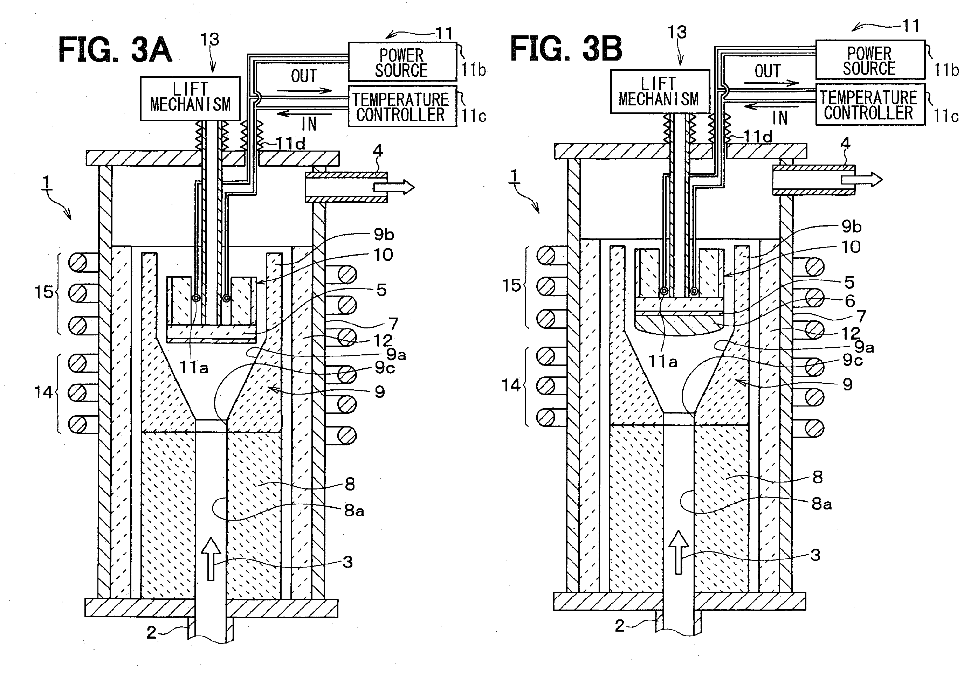

A manufacturing apparatus 1 of a SiC single crystal according to a second embodiment of the present invention will be described with reference to FIG. 3A and FIG. 3B. In the present embodiment, a height of a temperature control pipe 11a in a cooling system 11 can be changed. The other part of the manufacturing apparatus 1 according to the present embodiment is similar to the manufacturing apparatus 1 according to the first embodiment. Thus, only a part different from the first embodiment will be described.

As shown in FIG. 3A and FIG. 3B, the height of the temperature control pipe 11a from the circular plate 10a of the pedestal 10 can be controlled in a center axis direction of the pedestal 10. For example, the cooling system 11 further includes a bellows 11d attached to the temperature control pipe 11a. The bellows 11d can function as a height control portion. The hole of the vacuum chamber 7 in which the temperature control pipe 11a is inserted is closed with the bellows 11d so that the temperature control pipe 11a can be moved up and down while keeping a vacuum state. By controlling the position of the temperature control pipe 11a, the growth surface of the SiC single crystal 6 can be maintained at a predetermined temperature.

When the seed crystal 5 is disposed on the circular plate 10a of the pedestal 10, that is, before the SiC single crystal 6 grows on the seed crystal 5, as shown in FIG. 3A, the temperature control pipe 11a is at a distance from the circular plate 10a. When the SiC single crystal 6 grows, the temperature of the temperature control pipe 11a is controlled by being supplied with the induced current from the induction heating power source 11b and being supplied with the coolant from the coolant temperature controller 11c. Because the temperature of the growth surface increases with the growth of the SiC single crystal 6, as shown in FIG. 3B, the temperature control pipe 11a is moved closer to the circular plate 10a. The temperature control pipe 11a may be moved downward. In a case where the pedestal 10 is lifted up with the growth of the SiC single crystal 6, a lifted amount of the temperature control pipe 11a may be set to be smaller than a lifted amount of the pedestal 10 so that the temperature control pipe 11a is moved closer to the circular plate 10a. Accordingly, the growth surface of the SiC single crystal 6 can be maintained at the predetermined temperature.

As described above, in the manufacturing apparatus 1 according to the present embodiment, the height of the temperature control pipe 11a from the circular plate 10a of the pedestal 10 can be controlled. Thus, the temperature of the growth surface of the SiC single crystal 6 can be maintained at the predetermined temperature more certainly by controlling the height of the temperature control pipe 11a in addition to controlling the coolant supplied to the temperature control pipe 11a and controlling the induced current supplied to the temperature control pipe 11a. Therefore, the SiC single crystal 6 of high quality can be manufactured while restricting deposition of a SiC polycrystal around the pedestal 10.

### (Third Embodiment)

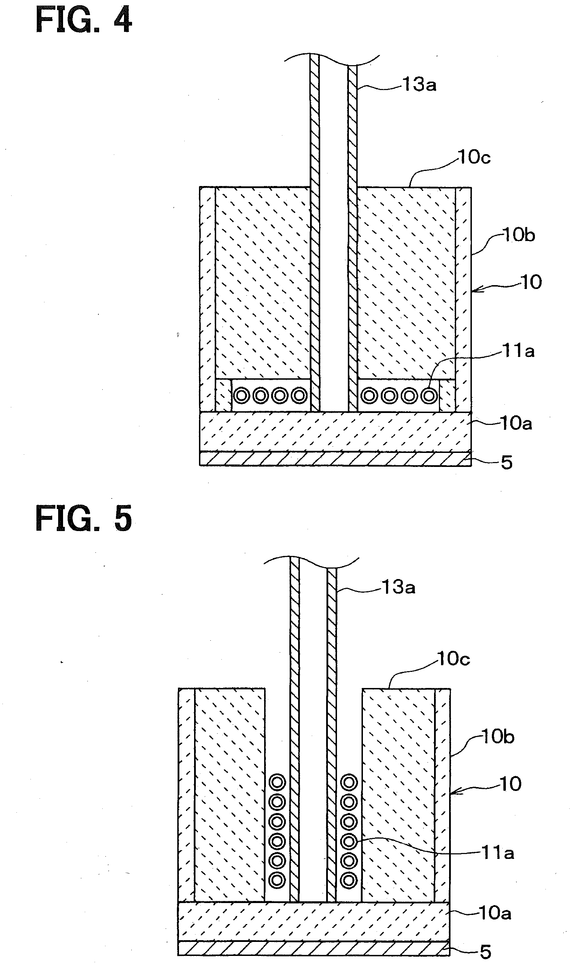

A manufacturing apparatus 1 of a SiC single crystal according to a third embodiment of the present invention will be described with reference to FIG. 4. In the manufacturing apparatus 1 according to the present embodiment, configurations of a pedestal 10 and a cooling system 11 are different from those of the first embodiment, and the other part of the manufacturing apparatus 1 is similar to the manufacturing apparatus 1 according to the first embodiment. Therefore, only a part different from the first embodiment will be described.

In FIG. 4, only a part of the manufacturing apparatus 1 in the vicinity of the pedestal 10 and a temperature control pipe 11a in the cooling system 11 is shown.

In the present embodiment, the temperature control pipe 11a is spirally arranged along the second surface of the circular plate 10a of the pedestal 10. The heat insulator 10c disposed in the housing portion 10b of the pedestal 10 covers an outer periphery and an upper side of the temperature control pipe 11a.

By spirally arranging the temperature control pipe 11a, the circular plate 10a of the pedestal 10 can be cooled at a wider area. Even when a SiC single crystal 6 having a large diameter is manufactured with a seed crystal 5 having a large diameter, the SiC single crystal 6 can be cooled at a wide area. Thus, even when a SiC single crystal 6 having a large diameter is manufactured, deposition of a SiC polycrystal around the pedestal 10 can be restricted.

In the example shown in FIG. 4, an upper side of the temperature control pipe 11a is covered with the heat insulator 10c. Thus, the height of the temperature control pipe 11a cannot be controlled as the second embodiment. When the upper side of the temperature control pipe 11a is not covered with the heat insulator 10c, the cooling system 11 may be configured so that the height of the temperature control pipe 11a can be changed.

### (Fourth Embodiment)

A manufacturing apparatus 1 of a SiC single crystal according to a fourth embodiment of the present invention will be described with reference to FIG. 5. In the manufacturing apparatus 1 according to the present embodiment, configurations of a pedestal 10 and a cooling system 11 are different from those of the first embodiment, and the other part of the manufacturing apparatus 1 is similar to the manufacturing apparatus 1 according to the first embodiment. Therefore, only a part different from the first embodiment will be described.

In FIG. 5, only a part of the manufacturing apparatus 1 in the vicinity of the pedestal 10 and a temperature control pipe 11a in the cooling system 11 is shown.

In the present embodiment, the temperature control pipe 11a is wound around the pipe 13a along a longitudinal direction of the pipe 13a in such a manner that the temperature control pipe 11a is arranged to a higher position.

By arranging the temperature control pipe 11a to the higher position, the amount (density) of the coolant that can flow in a part of the temperature control pipe 11a arranged in the pedestal 10 can be increased, and a cooling efficiency can be improved.

The cooling system 11 according to the present embodiment may also be configured so that the height of the temperature control pipe 11a can be changed in a manner similar to the second embodiment.

### (Fifth Embodiment)

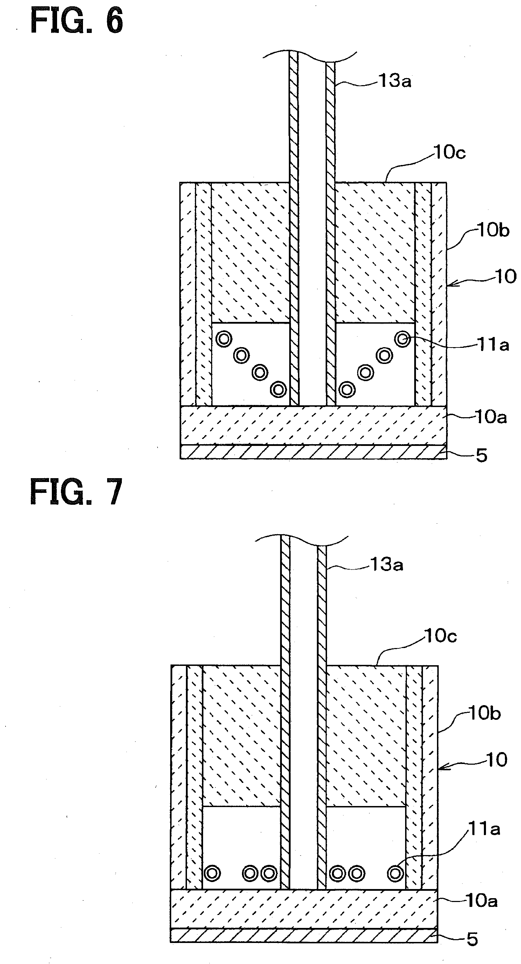

A manufacturing apparatus 1 of a SiC single crystal according to a fifth embodiment of the present invention will be described with reference to FIG. 6. In the manufacturing apparatus 1 according to the present embodiment, configurations of a pedestal 10 and a cooling system 11 are different from those of the third embodiment, and the other part of the manufacturing apparatus 1 is similar to the manufacturing apparatus 1 according to the third embodiment. Therefore, only a part different from the third embodiment will be described.

In FIG. 6, only a part of the manufacturing apparatus 1 in the vicinity of the pedestal 10 and a temperature control pipe 11a in the cooling system 11 is shown.

In the present embodiment, the temperature control pipe 11a is spirally arranged in such a manner that a distance between the temperature control pipe 11a and the second surface of the circular plate 10a increases with a distance from the pipe 13a.

By increasing the distance between the temperature control pipe 11a and the circular plate 10a of the pedestal 10 toward an outer periphery of the pedestal 10, the center portion of the circular plate 10a can be easily cooled, and a cooling rate can be changed in the circular plate 10a. Because the center portion of the circular plate 10a can be cooled more than a peripheral portion of the circular plate 10a, a temperature distribution can be provided in the growth surface of the SiC single crystal 6. Therefore, a growth rate of a center portion of the SiC single crystal 6 can be higher than the growth rate of a peripheral portion of the SiC single crystal 6, and the SiC single crystal 6 can convexly grow.

In the example shown in FIG. 6, an upper side of the temperature control pipe 11a is covered with the heat insulator 10c. Thus, the height of the temperature control pipe 11a cannot be controlled as the second embodiment. When the upper side of the temperature control pipe 11a is not covered with the heat insulator, the cooling system 11 may be configured so that the height of the temperature control pipe 11a can be changed.

### (Sixth Embodiment)

A manufacturing apparatus 1 of a SiC single crystal according to a sixth embodiment of the present invention will be described with reference to FIG. 7. In the manufacturing apparatus 1 according to the present embodiment, configurations of a pedestal 10 and a cooling system 11 are different from those of the third embodiment, and the other part of the manufacturing apparatus 1 is similar to the manufacturing apparatus 1 according to the third embodiment. Therefore, only a part different from the third embodiment will be described.

In FIG. 7, only a part of the manufacturing apparatus 1 in the vicinity of the pedestal 10 and a temperature control pipe 11a in the cooling system 11 is shown.

In the present embodiment, the temperature control pipe 11a is spirally arranged in such a manner that a density of the temperature control pipe 11a arranged above a center portion of the second surface of the circular plate 10a is higher than a density of the temperature control pipe 11a arranged above a peripheral portion of the second surface of the circular plate 10a.

Also by changing the density of the temperature control pipe 11a, the center portion of the circular plate 10a can be easily cooled, and a cooling rate can be changed in the circular plate 10a. Because the center portion of the circular plate 10a can be cooled more than the peripheral portion of the circular plate 10a, a temperature distribution can be provided in the growth surface of the SiC single crystal 6. Therefore, a growth rate of the center portion of the SiC single crystal 6 can be higher than the growth rate of the peripheral portion of the SiC single crystal 6, and the SiC single crystal 6 can convexly grow.

In the example shown in FIG. 7, an upper side of the temperature control pipe 11a is covered with the heat insulator 10c. Thus, the height of the temperature control pipe 11a cannot be controlled as the second embodiment. When the upper side of the temperature control pipe 11a is not covered with the heat insulator, the cooling system 11 may be configured so that the height of the temperature control pipe 11a can be changed.

### (Seventh Embodiment)

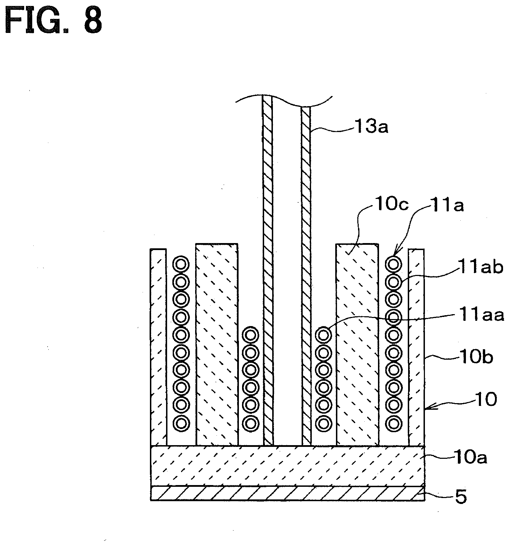

A manufacturing apparatus 1 of a SiC single crystal according to a seventh embodiment of the present invention will be described with reference to FIG. 8. In the manufacturing apparatus 1 according to the present embodiment, configurations of a pedestal 10 and a cooling system 11 are different from those of the first embodiment, and the other part of the manufacturing apparatus 1 is similar to the manufacturing apparatus 1 according to the first embodiment. Therefore, only a part different from the first embodiment will be described.

In FIG. 8, only a part of the manufacturing apparatus 1 in the vicinity of the pedestal 10 and a temperature control pipe 11a in the cooling system 11 is shown.

In the present embodiment, a heat insulator 10c is disposed between the pipe 13a and a housing portion 10b so as to divide a space in the housing portion 10b into an inner region inside the heat insulator 10c and an outer region outside the heat insulator 10c.

The temperature control pipe 11a according to the present embodiment includes a first temperature control pipe 11aa and a second temperature control pipe 11ab. The first temperature control pipe 11aa is disposed in the inner region and the second temperature control pipe 11ab is disposed in the outer region. Heating quantities and cooling quantities of the first temperature control pipe 11aa and the second temperature control pipe 11ab are independently controllable.

When a SiC single crystal 6 grows, the temperatures of the first temperature control pipe 11aa and the second temperature control pipe 11ab can be controlled by supplying the induced current from the induction heating power source 11b and supplying the coolant from the coolant temperature controller 11c. Both the first temperature control pipe 11aa and the second temperature control pipe 11ab may cool the circular plate 10a of the pedestal 10. Alternatively, the second temperature control pipe 11ab may heat the circular plate 10a. In the present case, the second temperature control pipe 11ab can heat the housing portion 10b from inside. Thus, the temperature control pipe 11a can heat the peripheral portion of the circular plate 10a while cooling the center portion of the circular plate 10a. Thus, a temperature difference can be provided between the center portion of the circular plate 10a and the peripheral portion of the circular plate 10a and deposition of a SiC polycrystal around the pedestal 10 can be restricted more efficiently.

### (Other Embodiments)

Although the present invention has been fully described in connection with the preferred embodiments thereof with reference to the accompanying drawings, it is to be noted that various changes and modifications will become apparent to those skilled in the art according to the appended claims.

In each of the above-described embodiments, the temperature control pipe 11a is a cooling pipe made of a RF coil so that the heating quantity of the temperature control pipe 11a can be controlled by supplying the induced current from the induction heating power source 11b and the cooling quantity of the temperature control pipe 11a can be controlled in accordance with a coolant temperature controlled with the coolant temperature controller 11c. The above-described configuration is merely an example. The temperature control pipe 11a may also be a cooling pipe in which a heating quantity cannot be controlled and a cooling quantity can be controlled with the coolant temperature controller 11c. When the heating quantity of the temperature control pipe 11a can be controlled by supplying the induced current from the induction heating power source 11b, the temperature of the temperature control pipe 11a can be finely controlled. Thus, the temperature of the growth surface of the SiC single crystal 6 can be finely controlled.

The temperature control pipe 11a may also have a configuration other than the examples in the above-described embodiments according to the appended claims. For example, the temperature control pipe 11a may include both a part that is spirally arranged as shown in FIG. 4 and a part that is wound around the pipe 13a along a longitudinal direction of the pipe 13a as shown in FIG. 5. In a configuration that the heat insulator 10c divides the space in the housing portion 10b into the inner region and the outer region as shown in FIG. 8, the number of windings of the first temperature control pipe 11aa disposed in the inner region may be larger than the number of windings of the second temperature control pipe 11ab disposed in the outer region.

In each of the above-described embodiment, the vacuum chamber 7 has the hole in which the temperature control pipe 11a is inserted.

## Claims

1. A manufacturing apparatus for growing a silicon carbide single crystal (6) on a surface of a seed crystal (5) that is made of a silicon carbide single crystal substrate by supplying a source gas (3) of silicon carbide from a lower side of a vacuum chamber (7) toward the seed crystal (5), comprising:
a pedestal (10) disposed in the vacuum chamber (7), the pedestal (10) having a first surface on which the seed crystal (5) is disposed and a second surface opposed to the first surface;
a rod member (13a) holding the pedestal (10); and
a cooling system (11) including a temperature control pipe (11a) and a coolant temperature controller (11c), the temperature control pipe (11a) disposed on a second surface side of the pedestal (10), the coolant temperature controller (11c) controlling a temperature of a coolant that flows to the temperature control pipe (11a),
**characterized in that**
the temperature control pipe (11a) makes at least one circuit around the rod member (13a).

2. The manufacturing apparatus according to claim 1, wherein:
the pedestal (10) includes a circular plate (10a), a housing portion (10b), and a heat insulator (10c);
the circular plate (10a) has the first surface and the second surface;
the housing portion (10b) is disposed on the second surface of the circular plate (10a) along a circumference of the circular plate (10a);
the heat insulator (10c) is disposed inside the housing portion (10b) and surrounds the rod member (13a); and
the temperature control pipe (11a) is disposed inside the heat insulator (10c).

3. The manufacturing apparatus according to claim 2, wherein:
the cooling system (11) further includes an induction heating power source (11b);
the cooling system (11) controls a heating quantity of the temperature control pipe (11a) by supplying electric power from the induction heating power source (11b) to the temperature control pipe (11a); and
the cooling system (11) controls a cooling quantity of the temperature control pipe (11a) by controlling the temperature of the coolant with the coolant temperature controller (11c).

4. The manufacturing apparatus according to any one of claims 1-3, wherein
the temperature control pipe (11a) is wound around the rod member (13a) along a longitudinal direction of the rod member (13a).

5. The manufacturing apparatus according to any one of claims 1-4, wherein
the cooling system (11) further includes a height control portion (11d) that controls a height of the temperature control pipe (11a) from the second surface of the pedestal (10).

6. A manufacturing method of a silicon carbide single crystal (6) using the manufacturing apparatus according to claim 5, comprising
growing the silicon carbide single crystal (6) on the seed crystal (5) that is made of a silicon carbide single crystal substrate while moving the temperature control pipe (11a) closer to the second surface of the pedestal (10) with growth of the silicon carbide single crystal (6).

## Patentansprüche

1. Herstellungsvorrichtung für ein Wachsen eines Siliziumkarbid-Einkristalls (6) an einer Fläche eines Keimkristalls (5), der aus einem Siliziumkarbid-Einkristall-Substrat gefertigt ist, durch ein Zuführen eines Quellengases (3) von Siliziumkarbid von einer unteren Seite einer Vakuumkammer (7) in Richtung des Keimkristalls (5), die aufweist:
einen Sockel (10), der in der Vakuumkammer (7) angeordnet ist, wobei der Sockel (10) eine erste Fläche, an der der Keimkristall (5) angeordnet ist, und eine zweite Fläche, die der ersten Fläche entgegengesetzt ist, hat,
ein Stabelement (13a), das den Sockel (10) hält, und
ein Kühlsystem (11), das ein Temperatursteuerungsrohr (11a) und eine Temperatursteuerungseinrichtung (11c) für ein Kühlmittel enthält, wobei das Temperatursteuerungsrohr (11a) an einer zweiten Flächenseite des Sockels (10) angeordnet ist, wobei die Temperatursteuerungseinrichtung (11c) für ein Kühlmittel eine Temperatur eines Kühlmittels, das zu dem Temperatursteuerungsrohr (11a) strömt, steuert,
**dadurch gekennzeichnet, dass**
das Temperatursteuerungsrohr (11a) zumindest eine Windung um das Stabelement (13a) herum macht.

2. Herstellungsvorrichtung entsprechend Anspruch 1, wobei:
der Sockel (10) eine kreisförmige Platte (10a), einen Gehäuseabschnitt (10b) und eine Wärmeisolationseinrichtung (10c) enthält,
die kreisförmige Platte (10a) die erste Fläche und die zweite Fläche hat,
der Gehäuseabschnitt (10b) an der zweiten Fläche der kreisförmigen Platte (10a) entlang eines Umfangs der kreisförmigen Platte (10a) angeordnet ist,
die Wärmeisolationseinrichtung (10c) im Inneren des Gehäuseabschnitts (10b) angeordnet ist und das Stabelement (13a) umgibt, und
das Temperatursteuerungsrohr (11 a) im Inneren der Wärmeisolationseinrichtung (10c) angeordnet ist.

3. Herstellungsvorrichtung entsprechend Anspruch 2, wobei:
das Kühlsystem (11) ferner eine Induktionswärmeleistungsquelle (11b) enthält,
das Kühlsystem (11) eine Wärmemenge des Temperatursteuerungsrohres (11a) durch ein Zuführen von elektrischer Leistung von der Induktionswärmeleistungsquelle (11b) zu dem Temperatursteuerungsrohr (11a) steuert, und
das Kühlsystem (11) eine Kühlmenge des Temperatursteuerungsrohrs (11a) durch ein Steuern der Temperatur des Kühlmittels mit der Temperatursteuerungseinrichtung (11c) für ein Kühlmittel steuert.

4. Herstellungsvorrichtung entsprechend einem der Ansprüche 1 bis 3, wobei
das Temperatursteuerungsrohr (11a) entlang einer Längsrichtung des Stabelements (13a) um das Stabelement (13a) herum gewunden ist.

5. Herstellungsvorrichtung entsprechend einem der Ansprüche 1 bis 4, wobei
das Kühlsystem (11) ferner einen Höhensteuerungsabschnitt (11d) enthält, der eine Höhe des Temperatursteuerungsrohres (11a) von der zweiten Fläche des Sockels (10) steuert.

6. Herstellungsverfahren eines Siliziumkarbid-Einkristalls (6) unter Verwendung der Herstellungsvorrichtung nach Anspruch 5, das aufweist
Wachsen-lassen des Siliziumkarbid-Einkristalls (6) an dem Keimkristall (5), der aus einem Siliziumkarbid-Einkristall-Substrat gefertigt ist, während des Bewegens des Temperatursteuerungsrohres (11a) näher an die zweite Fläche des Sockels (10) mit einem Wachstum des Siliziumkarbid-Einkristalls (6).

## Revendications

1. Appareil de fabrication pour le développement d'un monocristal de carbure de silicium (6) sur une surface d'un germe cristallin (5) qui est fait d'un substrat monocristallin de carbure de silicium par la fourniture d'un gaz source (3) de carbure de silicium à partir d'un côté inférieur d'une chambre à vide (7) vers le germe cristallin (5), comprenant :
un socle (10) disposé dans la chambre à vide (7), le socle (10) ayant une première surface sur laquelle le germe cristallin (5) est disposé et une seconde surface opposée à la première surface ;
un élément de tige (13a) retenant le socle (10) ; et
un système de refroidissement (11) comprenant un tuyau de réglage de température (11a) et un dispositif de réglage de température de fluide de refroidissement (11c), le tuyau de réglage de température (11a) disposé sur un second côté de surface du socle (10), le dispositif de réglage de température de fluide de refroidissement (11c) réglant une température d'un fluide de refroidissement qui s'écoule vers le tuyau de réglage de température (11a),
**caractérisé en ce que**
le tuyau de réglage de température (11a) forme au moins un circuit autour de l'élément de tige (13a).

2. Appareil de fabrication selon la revendication 1, dans lequel :
le socle (10) comprend une plaque circulaire (10a), une partie logement (10b), et un isolant thermique (10c) ;
la plaque circulaire (10a) a la première surface et la seconde surface ;
la partie logement (10b) est disposée sur la seconde surface de la plaque circulaire (10a) le long d'une circonférence de la plaque circulaire (10a) ;
l'isolant thermique (10c) est disposé à l'intérieur de la partie logement (10b) et entoure l'élément de tige (13a) ; et
le tuyau de réglage de température (11a) est disposé à l'intérieur de l'isolant thermique (10c).

3. Appareil de fabrication selon la revendication 2, dans lequel :
le système de refroidissement (11) comprend en outre une source d'énergie de chauffage par induction (11b) ;
le système de refroidissement (11) règle une quantité de chauffage du tuyau de réglage de température (11a) en fournissant de l'énergie électrique de la source d'énergie de chauffage par induction (11b) au tuyau de réglage de température (11a) ; et
le système de refroidissement (11) règle une quantité de refroidissement du tuyau de réglage de température (11a) en réglant la température du fluide de refroidissement avec le dispositif de réglage de température de fluide de refroidissement (11c).

4. Appareil de fabrication selon l'une quelconque des revendications 1 à 3, dans lequel le tuyau de réglage de température (11a) est enroulé autour de l'élément de tige (13a) le long d'une direction longitudinale de l'élément de tige (13a).

5. Appareil de fabrication selon l'une quelconque des revendications 1 à 4, dans lequel le système de refroidissement (11) comprend en outre une partie de réglage de hauteur (11d) qui règle une hauteur du tuyau de réglage de température (11a) par rapport à la seconde surface du socle (10).

6. Procédé de fabrication d'un monocristal de carbure de silicium (6) utilisant l'appareil de fabrication selon la revendication 5, comprenant :
la croissance du monocristal de carbure de silicium (6) sur le germe cristallin (5) qui est fait d'un substrat monocristallin de carbure de silicium tout en déplaçant le tuyau de réglage de température (11a) plus près de la seconde surface du socle (10) pendant la croissance du monocristal de carbure de silicium (6).
